**Europäisches Patentamt**

(19) **European Patent Office**

**Office européen des brevets**

(11) Numéro de publication: **0 013 843**
**B1**

(12) # FASCICULE DE BREVET EUROPEEN

(45) Date de publication du fascicule du brevet:
**16.10.85**

(51) Int. Cl.⁴: **G 01 R 19/03,** H 02 J 3/14,
G 01 R 17/10

(21) Numéro de dépôt: **79400823.5**

(22) Date de dépôt: **06.11.79**

(54) Détecteur d'intensité de courant pour installations de régulations de puissance d'appareils électrodomestiques.

(30) Priorité: **28.11.78 FR 7833602**

(43) Date de publication de la demande:
**06.08.80 Bulletin 80/16**

(45) Mention de la délivrance du brevet:
**16.10.85 Bulletin 85/42**

(84) Etats contractants désignés:
**AT BE CH DE GB IT NL SE**

(56) Documents cités:
**FR - A - 1 495 557**
**FR - A - 2 183 715**
**US - A - 3 696 294**
**US - A - 4 060 709**

**Le dossier contient des informations techniques présentées postérieurement au dépôt de la demande et ne figurant pas dans le présent fascicule.**

(73) Titulaire: **Girard, François Marie, 29 Rue Eugène Bussière, F-21000 Dijon (FR)**

(72) Inventeur: **Girard, François Marie, 29 Rue Eugène Bussière, F-21000 Dijon (FR)**

### Description

La présente invention concerne un détecteur d'intensité de courant pour une installation de régulation de la puissance consommée par un ensemble d'appareils électro-domestiques.

Dans une telle installation le courant total est limité par un disjoncteur central de protection qui interrompt l'alimentation de l'ensemble lors du dépassement de la consommation limite autorisée définie par le contrat d'abonnement. Lorsqu'on s'approche de cette limite il est donc souhaitable de répartir la puissance disponible sur les différents appareils branchés dans le circuit. Dans le cadre d'une telle répartition on peut prévoir des appareils prioritaires qui ne sont pas soumis à une limitation et d'autres appareils qui feront l'objet d'une régulation dès que le courant total consommé atteint son maximum toléré.

Une solution simple pour la régulation de la puissance consommée consiste à débrancher automatiquement certains appareils et à les commander ainsi selon un mode tout ou rien. Dans le cas d'une installation domestique, dont la dimension est généralement réduite, un tel procédé entraîne cependant un fonctionnement anormal qui s'explique de la manière suivante:

L'intensité totale I, dont le dépassement d'une valeur prédéterminée $I_d$ doit entraîner le délestage, est constituée par la somme des intensités des courants des différents appareils soit: $I = i + i_1 + i_2 + ...$, où i représente le courant d'un appareil prioritaire, $i_1$ le courant du premier appareil qui sera coupé en cas de dépassement de $I_d$, $i_2$ celui du deuxième appareil coupé si la suppression de $i_1$ ne suffit pas, etc. Si, à un instant donné t, le courant i atteint une intensité $i_t$ telle que $I_t = i_t + i_1 + i_2 + ... = I_d + \Delta I$, le courant total dépasse la limite donnée de $\Delta I$; à l'instant $t + \varepsilon$ le courant $i_1$ aura été supprimé par le délestage, de sorte que $I_{t+\varepsilon} = i_{t+\varepsilon} + i_2 ...$

L'intervalle $\varepsilon$ étant de l'ordre de 10 ms, c'est-à-dire environ une demi-période du courant, on peut considérer que $i_t = i_{t+\varepsilon}$. Le nombre d'appareils branchés dans une installation domestique et la puissance relativement importante des différents appareils par rapport à l'ensemble font que $i_1$ est toujours très grand par rapport à $\Delta I$. Ainsi, à l'instant $t + \varepsilon$, le courant total $I_{t+\varepsilon}$ sera de nouveau sensiblement inférieur à $I_d$, de sorte que le courant $i_1$ sera de nouveau enclenché et le relais d'enclenchement de ce courant va battre avec une période d'environ 20 ms à 1 s selon l'inertie de ce relais. Un tel fonctionnement est bien entendu prohibé.

On peut remédier partiellement à ce problème en utilisant une minuterie dans le dispositif de commande des appareils servant au délestage. On réalise ainsi un temps de réaction relativement long, par exemple de 5 à 15 mn et, à la fin de cet intervalle, trois cas peuvent se présenter: Soit $i + i_2 + ... > I_d$ et le délestage est maintenu. Soit $i + i_2 + ... < I_d < i + i_1 + i_2 + ...$ et le courant $i_1$ est enclenché et coupé aussitôt pour une nouvelle période correspondant au cycle de la minuterie.

Il se produit donc un battement du relais de réenclenchement. Soit $i + i_1 + i_2 + ... < I_d$ et le contacteur réenclenche l'appareil à courant $i_1$ de manière permanente. Cette solution ne permet donc pas d'éviter complètement les battements de relais et ne permet pas d'utiliser au maximum la puissance disponible. Cette perte de puissance disponible est non négligeable dans les installations domestiques, car $i_1$ est grand par rapport à I et le temps de réenclenchement de la minuterie est choisi long pour diminuer les battements.

On a par conséquent envisagé une régulation de puissance des différents appareils: à cet égard il est à noter qu'un réglage de phase est prohibé par la norme française NF C 70–100 pour des éléments chauffants ou d'appareils thermiques d'une puissance supérieure à 200 W en raison des perturbations apportées sur le réseau, et est donc exclu pour des applications domestiques.

Une solution permise pour des résistances thermiques consiste à commander la réduction de puissance par trains d'impulsions entières. Toutefois des conditions de chute de tension sont imposées en fonction de la fréquence des commutations. En effet, les trains d'impulsions sont suffisamment longs, à savoir de 100 ms à quelques dizaines des s, pour que le début ou la fin du train d'impulsion soit assimilable à une commutation qui entraîne une chute de tension sur le réseau, perceptible par la variation de luminance des lampes à filament. Cette perturbation est limitée par la norme française précitées (point 5.4) en ce sens que plus l'intensité commandée est importante, plus l'intervalle de temps entre deux commutations doit être grand. Par exemple, pour pouvoir réduire la puissance des radiateurs, chauffe-eau, cuisinières, installations d'éclairage domestique, il faut que le nombre de commutations par mn soit de l'ordre de 5 à 10. C'est dire que ce type de régulation de puissance est assimilable à l'échelle des temps de réponse des dispositifs de détection de courant usuels, p. ex. tels que décrits dans le brevet USA 3 423 598, à une coupure totale et engendre par conséquent des battements tels que mentionnés plus haut, et d'ailleurs prohibés en raison des chutes de tension qu'ils produisent. L'utilisation de ce procédé nécessite donc un détecteur de courant réalisant des fonctions multiples pour éviter ces inconvénients.

L'invention vise à fournir un détecteur de courant parfaitement adapté pour l'utilisation dans une installation de régulation de la puissance consommée par des appareils électro-domestiques commandés par trains d'impulsions entières et pour des intensités domestiques. L'invention vise notamment à fournir un détecteur de construction particulièrement simple et peu volumineuse. L'installation de régulation de puissance utilisant un tel détecteur comporte un minimum de connexions entre les différents appareils.

Pour réaliser un détecteur d'intensité simple et de petite dimension, il est connu (document US-A-3 696 294) que l'on peut obtenir un signal analogique linéaire en plaçant 2 thermistances dans un montage en Pont de Weaston avec l'une des thermistances à proximité d'un élément chauffant parcouru par le courant à mesurer et l'autre thermistance disposée de manière à n'être pas affectée par la chaleur dégagée par l'élément chauffant en le plaçant par exemple sous vide (document FR-A-1 495 557) et servant donc de compensation de température ambiante.

Tous les dispositifs connus cherchent à obtenir une mesure de courant alternatif (valeur efficace) en réalisant une courbe de réponse la plus linéaire possible. Dans le cas de courant alternatif, la mesure de forts courants ne se pose pas puisque les transformateurs d'intensités sont fiables et précis. Les dispositifs connus se limitent donc à de faibles intensités (moins de 1 ampère), d'autant plus que la linéarité devient difficile à réaliser pour les forts courants, et que les temps de réponse exigés pour effectuer une mesure sont petits (moins de 1 seconde). Des éléments constitutifs de petites dimensions pour mesurer de très faibles courants (moins de 1 ampère), comportent des masses thermiques faibles et donc des temps de réponse rapides.

De tels dispositifs rapides et linéaires ne résolvent pas le problème précédemment exposé page 2 ligne 22 à page 2 ligne 7.

Le détecteur d'intensité selon l'invention est défini par la revendication 1. Ce détecteur peut comporter au moins une résistance auxiliaire montée en série entre les deux thermistances, au moins deux conducteurs de sortie étant connectés aux bornes de cette résistance pour fournir des potentiels de sortie à deux niveaux différents.

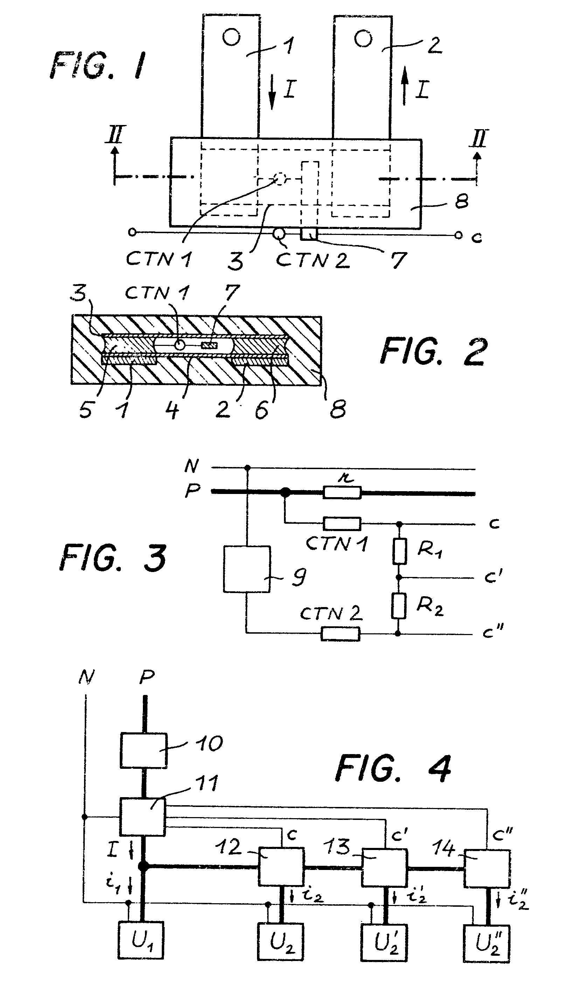

Une autre forme de réalisation de l'invention consiste à obtenir l'élément chauffant 4 à partir d'un circuit imprimé. La forme de l'élément 4 sera dessinée et obtenue directement par la photographie sur le circuit imprimé. Sur ce même circuit imprimé les connexions nécessaires pour réaliser le schéma électrique de la figure 3 seront obtenues par la même opération de photographie et ainsi tous les composants nécessaires prendront place sur ce circuit. Les thermistances CTN 1 et CTN 2 qui seront prépositionnées sur le circuit seront enrobées de résine spéciale en même temps que tous les composants.

Cette réalisation permet d'atteindre des coûts de fabrication très bas. En effet les pièces 3, 5, 6 sont supprimées et il n'y a plus qu'une seule opération de coulée de résine.

L'installation de régulation utilisant un détecteur de courant selon l'invention est telle que ledit détecteur est monté sur une ligne de courant d'alimentation primaire d'un ensemble d'appareils électro-domestiques et que des dispositifs de commande et de régulation sont intercalés dans cette ligne d'alimentation en amont de chaque appareil dont l'alimentation est susceptible d'être commandée pour délester le circuit, chaque dispositif de commande étant relié au détecteur de courant par l'un des conducteurs de sortie de ce détecteur.

D'autres caractéristiques et avantages de l'invention ressortiront de la description d'une forme de réalisation du détecteur et de l'installation de régulation, donnée ci-après à titre d'exemple non limitatif et illustrée dans les dessins annexés, dans lesquels

la figure 1 est une représentation schématique du détecteur d'intensité de courant selon l'invention;

la figure 2 est une coupe selon la ligne II de la figure 1;

la figure 3 est le schéma électrique d'un détecteur selon l'invention;

la figure 4 est le schéma synoptique d'une installation de régulation équipée du détecteur de courant selon l'invention;

la figure 5 est le schéma synoptique d'un dispositif de commande et de régulation utilisé dans le schéma de la fig. 4; et

la figure 6 est un diagramme des formes d'onde en différents points du dispositif selon la fig. 5.

La figure 1 est une vue en plan schématique d'un détecteur de courant comportant deux barres conductrices 1, 2 disposées parallèlement et reliées entre elles, à une de leurs extrémités, par deux lames chauffantes 3, 4, superposées à une faible distance l'une de l'autre. Ces lames sont par exemple reliées entre elles à la hauteur des barres conductrices par une masse de liant conducteur obtenue par exemple par une soudure à l'étain tel que cela est indiqué en 5, 6 à la figure 2. Une thermistance CTN 1, en forme de perle, est disposée entre les deux lames chauffantes et connectée électriquement d'une part à la barre conductrice 1 et, d'autre part, à une barrette conductrice 7. L'ensemble des extrémités des barres conductrices 1, 2 et des lames chauffantes est enrobé dans une matière électriquement isolante et légèrement conductrice de la chaleur, telle qu'une résine époxy chargée de façon à former un bloc isolant 8. Une deuxième thermistance CTN 2, également en forme de perle, est disposée à la périphérie du bloc 8, cette deuxième thermistance ayant d'une part une connexion d'alimentation n et étant d'autre part connectée à la barrette conductrice 7. Cette dernière est connectée à un conducteur de sortie c.

Le dimensionnement de ce détecteur de courant est déterminé par les trois fonctions suivantes que le détecteur doit réaliser:

a) fournir une tension de commande (potentiel du conducteur de sortie c) qui soit l'image du courant moyen I avec intégration de variations régulières d'une période d'environ 5 à 20 s.

b) réagir rapidement, c'est-à-dire dans un temps de réaction de l'ordre de 5 s, à des augmentations brusques, non périodiques de I.

c) fournir une tension de commande qui soit une fonction non linéaire du courant I, de sorte qu'à un point donné une faible variation de I entraîne une forte baisse du potentiel sur le conducteur de sortie c.

La figure 3 montre le schéma électrique d'un détecteur de courant selon l'invention dans le cas où l'on désire obtenir plusieurs potentiels de sortie c, c', c''. Les lames chauffantes 3, 4 forment une résistance électrique r intercalée dans le conducteur de phase p de l'installation. La thermistance CTN 1 est connectée d'un côté à ce conducteur de phase P et de l'autre côté au conducteur de sortie c. La thermistance CTN 2 est connectée d'une part, c'est-à-dire par sa connexion n, par l'intermédiaire d'un dispositif d'alimentation 9, au conducteur neutre N de l'installation et, de l'autre côté, soit directement au conducteur de sortie c, comme dans la figure 1, soit, comme le montre la fig. 3, par l'intermédiaire d'une ou plusieurs résistances telles que $R_1$, $R_2$. Aux bornes de ces résistances apparaissent les potentiels de sortie c, c', c''.

Le montage en série des thermistances CTN 1 et CTN 2 est alimenté par une tension continue dérivée de la tension d'alimentation principale apparaissant entre les lignes P, N, au moyen du dispositif d'alimentation, qui comporte par exemple une résistance montée en série avec un dispositif redresseur. Le courant passant dans les thermistances CTN 1 et CTN 2 est fonction des températures régnant à l'endroit où sont disposées ces thermistances et détermine la valeur de la tension de commande apparaissant sur le conducteur de sortie c. Dans le cas du montage de la fig. 3, deux autres niveaux de tension de sortie correspondants c', c'', sont obtenus aux bornes et la résistance $R_2$. Le rôle de la thermistance CTN 2 est de réaliser une compensation de température ambiante et de faire en sorte que la tension de commande C soit déterminée par le gradient de température qui s'établit entre les deux thermistances.

Une autre manière de réaliser cette fonction de compensation de température ambiante consiste à noyer dans la résine, à une certaine distance de la thermistance CTN 1, une résistance chauffante R qui maintiendra la température constante à une valeur sensiblement supérieure à l'ambiante. Cette résistance crée les conditions pour que la fidélité du rapport entre la tension C et l'intensité de courant détectée soit convenable, puisque les variations de l'environnement extérieur auront peu d'effet sur le gradient de température entre CTN 1 et R.

La fonction a) susmentionnée est réalisée de la manière suivante. En régime permanent, lorsque l'intensité du courant consommée par le ou les appareils prioritaires est constante et que l'intensité du courant additionnel dans les appareils non prioritaires est réglée dans l'installation, la chaleur produite au niveau des lames chauffantes 3, 4 s'évacue par l'intermédiaire du bloc 8, de sorte que la thermistance CTN 2 enregistre une légère augmentation de température par rapport à la température ambiante. Les thermistances CTN 1 et CTN 2 étant montées de la façon décrite, la tension de commande c est déterminée par le gradient de température qui s'établit entre les deux thermistances. L'inertie thermique de la matière solide du bloc 8, déterminée par la qualité et la quantité de cette matière, est choisie de façon que des variations régulières de période de 5 à 20 s environ soient intégrées. Les valeurs des thermistances sont choisies de façon que la tension de sortie sur le conducteur c soit indépendante de la température des thermistances elles-mêmes et donc des conditions d'évacuation de la chaleur produite, plus particulièrement de la température extérieure au détecteur. Il est à noter que la quantité de chaleur dégagée par le détecteur reste de toute manière extrêmement faible et que les températures de travail restent sans danger pour la sécurité de l'installation.

Ainsi, le bloc 8 joue le rôle d'un volant thermique et atténue, à la manière d'un condensateur, les variations régulières pouvant se produire une fois qu'un régime permanent s'est établi et que les températures se sont stabilisées.

La fonction b) doit permettre au détecteur de réagir rapidement lorsqu'un appareil prioritaire puissant est mis en service et que de ce fait l'intensité $I_d$ est dépassée. Pour réaliser cette fonction, la thermistance CTN 1 et les lames chauffantes 3, 4 sont dimensionnées de façon à présenter une inertie thermique très faible et les distances entre ces lames et la thermistance ainsi que la quantité de matière solide entre elles sont très faibles. Il s'ensuit que la chaleur additionnelle engendrée par la mise en service de l'appareil puissant est transmise rapidement à la thermistance CTN 1 et beaucoup plus lentement à la thermistance CTN 2. La régulation, après avoir modifié le régime impulsionnel, sera de nouveau stable lorsque la chaleur moyenne, dégagée en présence de l'appareil puissant, établira sensiblement le même gradient de température entre CTN 1 et CTN 2 que précédemment.

Cette sensibilité à des élévations de l'intensité de courant brutales est particulièrement précieuse dans les installations domestiques où le nombre d'appareils puissants est très limité, ce qui entraîne des variations d'intensité représentant un pourcentage très élevé (500 à 1000%). Le détecteur réagit donc très rapidement à tout dépassement de la consommation limite.

La fonction c) susmentionnée s'explique comme suit. Dans un système linéaire, la courbe de réponse c = f (I) du détecteur étant linéaire, une augmentation de l'intensité de courant dI serait transformée dans l'installation en une diminution de l'intensité à régler, la différence entre ces deux variations étant constante pour tous les points de la caractéristique de régulation. Il s'ensuit que la puissance moyenne, à laquelle commence le délestage, doit être inférieure à la puissance limite correspondante Id, pour qu'en fin de délestage le courant maximal soit toujours inférieur à $I_d$. Dans les usages domestiques, la puissance à délester peut être suffisamment importante par rapport à la puissance limite pour qu'on soit obligé de choisir une puissance de seuil, à laquelle commence le délestage, relativement basse. Ceci réduit la possibilité d'utiliser le maximum de puissance disponible quelque soit le mode d'utilisation.

Dans le présent détecteur d'intensité, on utilise la propriété d'une thermistance de s'auto-échauffer à partir d'une certaine température sous l'effet du courant qui traverse la thermistance. Dans cette zone de fonctionnement, une faible variation

du courant primaire I entraîne un très faible apport de chaleur qui, cependant, combiné avec l'auto-échauffement de la thermistance, suffit à produire une forte diminution de la résistance de la thermistance et, par conséquent, une forte baisse de la tension de sortie sur le conducteur c. On réalise ainsi une tension de commande non linéaire en fonction du courant I, ce qui permet de rapprocher sensiblement les valeurs de la puissance à partir de laquelle le délestage doit commencer et la puissance limite correspondant au courant $I_d$.

La figure 4 montre schématiquement une installation de régulation de puissance équipée du détecteur de courant selon l'invention. L'installation comporte par exemple quatre appareils électro-domestiques, dont le premier $U_1$ est un appareil prioritaire, tandis que les trois autres appareils $U_2$, $U'_2$, $U''_2$ sont des appareils soumis à une régulation en cas de dépassement de la consommation totale permise. Ces différents appareils sont alimentés à partir d'un conducteur de phase P et d'un conducteur neutre N, d'autres conducteurs de phase éventuellement utilisés n'étant pas représentés pour simplifier le schéma. Dans la ligne d'alimentation P est inséré un disjoncteur 10 et, en série avec ce dernier, est monté un appareil détecteur de courant 11. Soit I le courant primaire d'alimentation surveillé par l'appareil 11, qui correspond au schéma de la fig. 3, et $i_1$, $i_2$, $i_2'$, $i_2''$ les courants respectifs des appareils $U_1$, $U_2$, $U_2'$, $U_2''$.

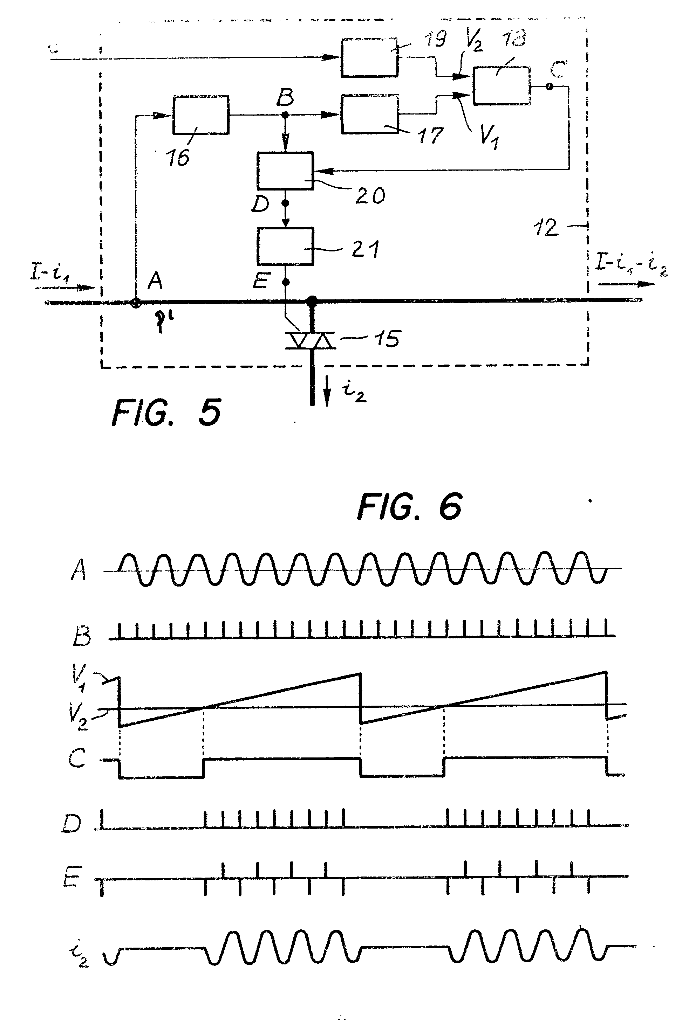

L'appareil prioritaire $U_1$ est alimenté directement, tandis que les appareils soumis à régulation sont alimentés par l'intermédiaire de dispositifs de commande et de régulation respectifs 12, 13, 14, qui peuvent tous avoir la même structure interne telle que représentée à la figure 5. Ces dispositifs peuvent être connectés en série sur la ligne P' dérivée de la ligne P, et sont reliés à l'appareil 11 au moyen de lignes de commande respectives c, c', c''.

L'appareil détecteur de courant 11 fournit en fonction de l'intensité de courant I des tensions de commande de trois niveaux différents respectivement sur les conducteurs c, c', c''. Sous l'effet de ces tensions de commande les appareils de commande et de régulation effectuent une régulation du courant fourni aux appareils $U_2$, $U_2'$, $U_2''$ de la matière décrite en rapport avec les figures 5 et 6. Le schéma de la figure 4 illustre le fait qu'une seule ligne de commande est nécessaire pour la commande des appareils de commande et de régulation, ces derniers étant intercalés dans la ligne d'alimentation des différents appareils utilisés et pouvant, par conséquent, être connectés directement à ceux-ci. Par ailleurs, l'utilisation de différents niveaux de tension de commande permet de différencier la régulation des différents appareils concernés, autrement dit de définir un ordre de priorité dans l'ensemble des appareils intervenant dans le délestage de l'installation.

Le figure 5 montre à titre d'exemple le schéma synoptique d'un dispositif de commande et de régulation 12 tel qu'il est utilisé dans une installation selon la figure 4. Un dispositif de régulation est représenté sous forme d'un triac 15 inséré dans la ligne d'alimentation dérivée de la ligne P' pour alimenter l'appareil $U_2$ non représenté sur la figure 5.

Le triac 15 est commandé à sa gâchette par un potentiel E fourni par la partie de commande du dispositif 12, elle-même commandée par le potentiel apparaissant sur le conducteur de sortie c de l'appareil détecteur 11.

La figure 6 représente les formes d'onde apparaissant en différents points du dispositif 12, désignés de la même façon que les diagrammes correspondants de la figure 6.

La tension d'alimentation alternative est appliquée à partir d'un point A de la ligne P' à un détecteur de passage à zéro 16, qui délivre une série d'impulsions B coincidant avec les instants de passage à zéro de la tension alternative. Ces impulsions déclenchent périodiquement un générateur de rampe 17 qui fournit à sa sortie une tension en dents de scie $V_1$. La tension $V_1$ est appliquée à un comparateur de tension 18 recevant sur une autre entrée une tension continue $V_2$ proportionnelle à la tension du signal de commande c apparaissant sur le conducteur de sortie de l'appareil 11. La tension $V_2$ est obtenue par l'intermédiaire d'un amplificateur 19. Le comparateur 18 délivre un signal en créneaux C qui commande un hacheur 20, auxquels sont appliquées d'autre part les impulsions P. Ainsi à la sortie D du hacheur 20 les impulsions B sont supprimées dans les intervalles où la tension $V_2$ est supérieure à la tension $V_1$. Les impulsions apparaissant au point D commandent un générateur d'impulsions 21 qui fournit des trains d'impulsions E propres à commander d'allumage du triac 15 par sa gâchette. Le triac 15 découpe ainsi la tension du réseau en trains d'alternances entières, dont la longueur correspond à celle des créneaux positifs de la tension C, c'est-à-dire aux intervalles pendant lesquels $V_2$ est inférieur à $V_1$. Lorsque le potentiel sur le conducteur de sortie c de l'appareil détecteur 11 augmente, la longueur des trains d'impulsions de courant $i_2$ diminue et inversement.

Pour faire apparaître un seuil au-dessous duquel le dispositif de régulation ne produit aucune réduction du courant fourni à l'appareil $U_2$, on peut prévoir une tension continue de polarisation réglable qui est ajoutée aux tensions $V_1$ ou $V_2$ de manière à commander le triac 15 à chaque alternance.

La présente invention permet ainsi de réaliser une régulation de puissance de différents appareils électriques, en respectant les prescriptions relatives aux installations domestiques, par des moyens très simples, économiques et peu encombrants, propriétés particulièrement importantes pour de telles installations. Cet avantage provient essentiellement de la structure simple, fiable et peu volumineuse de l'appareil détecteur comportant un minimum de composants et pouvant être fabriqué en grande série de façon économique. De plus, la conception de l'ensemble de l'installation elle-même permet de réaliser le délestage voulu des appareils électro-domestiques concernés en utilisant des dispositifs de commande et de régulation simples et compacts nécessitant un minimum de moyens de montage et de lignes de connexion. L'invention rend ainsi accessible au domaine domestique les avantages considérables que représente le délestage pour la collectivité des consommateurs d'énergie électrique autant que pour le particulier.

**Revendications**

1. Détecteur d'intensité pour une installation de régulation en fonction de la demande globale de puissance consommée par un ensemble d'appareils électro-domestiques, comprenant les unités suivantes:
— un circuit constitué par 2 barres conductrices (1, 2) parcourues par le courant total et montées en série au moyen d'un élément conducteur (3, 4) qui forme un élément de chauffage,
— une première thermistance (CTN 1) disposée au voisinage de l'élément de chauffage,
— une deuxième thermistance (CTN 2), les deux thermistances étant montées en série entre un point du circuit parcouru par le courant total en amont de l'élément de chauffage et un autre point avec un potentiel différent de celui des barres conductrices,
— un signal de régulation étant produit au point de connexion des deux thermistances,
caractérisé en ce que
— l'élément de chauffage (3, 4) et la première thermistance (CTN 1) sont enrobés dans un bloc (8) de matière solide électriquement isolante et ayant une inertie thermique sensiblement plus grande que celle de l'élément de chauffage,
— la deuxième termistance se trouve à l'extérieur du bloc de matière solide et près de celui-ci,
— le dimensionnement des distances entre lesdites unités et des inerties thermiques desdites unités étant tel que le signal de régulation soit une image de la moyenne de l'intensité du courant total avec intégration de variations régulières dudit courant total sur une période de 5 à 20 secondes, tout en suivant des augmentations brusques de ce courant total dans un temps de réaction de l'ordre de 5 secondes.

2. Détecteur selon la revendication 1, caractérisée en ce que l'élément de chauffage est constitué par deux lamelles (3, 4) espacées l'une de l'autre et disposées parallèlement en regard l'une de l'autre, en ce que la première thermistance (CTN 1) est placée entre lesdites deux lamelles et en ce que le bloc de matière solide est constitué par une résine chargée dont la conductivité thermique et la masse totale sont déterminées de façon à obtenir l'inertie thermique désirée dudit bloc.

3. Détecteur selon les revendications 1 ou 2, caractérisé en ce qu'il comporte en outre une résistance chauffante noyée dans le bloc (8) de matière solide, de manière à maintenir ledit bloc avec un écart de température constant au-dessus de la température ambiante.

4. Détecteur selon la revendication 1 ou 3 en tant que dépendante de la revendication 1, caractérisé en ce que l'élément de chauffage est constitué par une pièce unique, en ce que la première thermistance est située à proximité dudit élément de chauffage, celui-ci étant directement obtenu par photographie sur un circuit imprimé, le bloc de matière solide étant formé de résine chargée dont la conductivité thermique et la masse totale sont déterminées de façon à obtenir l'inertie thermique désirée dudit bloc.

**Claims**

1. Intensity detector for a regulation setting up in relation to the total power demand used by an assembly of electro-domestic devices comprising the following units:
— a circuit made of 2 conducting rods (1, 2) crossed by the total current and set up in series through a conducting element (3, 4) which forms a heating element,
— a first thermistance (NTC 1) placed close to the heating element,
— a second thermistance (NTC 2) the two thermistances being set up in series between a point of the circuit crossed by the total current upstream the heating element and another point with a different potential of that of the conducting rods,
— a regulation signal being completed at the connecting point of the two thermistances,
being distinguished by the fact that:
— the heating element (3, 4) and the first thermistance (NTC 1) are wrapped in a block (8) of solid material, electrically insulating and having a thermic inertia slightly higher than that of the heating element,
— the second thermistance is located outside the block of solid material and close to it,
— the dimensioning of the distances between said units and of the thermic inertia of said units are such that the regulation signal is a picture of the average of the intensity of the total currents with integration of steady variations of said total current, over a period of 5 to 20 seconds, while following sudden increases of that total current within a response time of about 5 seconds.

2. Detector owing to claim 1, distinguished by the fact that the heating element is composed of two laminations (3, 4) far a part each other and placed parallelly to each other so that the first thermistance (NTC 1) is placed between said two laminations and so that the block of solid material is composed of a loaded resin the thermic conducting of which and the total mass are determined so that to obtain the thermic inertia desired of the said block.

3. Detector owing to claim 1 or two, distinguished by the fact that it comprises moreover a heating resistance drowned in the block (8) of solid material in order to maintain said block with a steady temperature deflection above the room temperature.

4. Detector following to claim 1 or 3 as depending on claim number 1, distinguished by the fact that the heating element is made of one sole part, and by the fact that the first thermistance is located close to the said heating element, this being directly obtained by photography on a printed circuit, the block of solid material being made of loaded resin, the thermic conductivity of which, and the total mass are determined in such a way to obtain the desired thermic inertia of the said block.

**Patentansprüche**

1. Intensitätsdetektor für die Regulierungsanlage gemessen der globalen Nachfrage des Leistungsverbrauches eines elektronischen Haushaltgerät-Komplexes bestehend aus den folgenden Einheiten:
– ein Kreislauf bestehend aus zwei leitenden Stromschienen (1, 2) vom Gesamtstrom durchlaufen und mittels eines leitenden Elementes (3, 4), das ein Heizelement darstellt, vorgeschaltet.
– ein erster temperaturabhängiger Widerstand (Thermistor) (CTN 1) installiert in der Nähe des Heizelementes.
– ein zweiter Thermistor (CTN 2), die zwei Thermistoren zwischen einem vom Gesamtstrom durchflossenen Punkt des Kreislaufes, oberhalb des Heizelementes liegend, und einem anderen Punkt mit einer der der Stromschienen unterschiedlichen Spannung vorgeschaltet.
– ein Regulierungssignal entstanden am Verbindungspunkt der beiden Thermistoren sich folgendermassen auszeichnend:
– das Heizelement (3, 4) und der erste Thermistor (CTN 1) eingefasst in einem Block (8) solider, elektronisch isolierender Materie, einen Wärmeleitwiderstand aufweisend, der bedeutend grösser als der des Heizelementes ist
– der zweite Thermistor (CTN 2) sich ausserhalb des Blockes solider Materie in dessen Nähe befindend.

– Die Dimensionierung der Distanzen zwischen den genannten Einheiten und den Wärmeleitwiderständen der genannten Einheiten in der Form, dass das Regulierungssignal eine Widerspiegelung des Durchschnitts des Gesamtstroms sei, unter Berücksichtigung der regelmässigen Variationen des genannten Gesamtstromes über eine Zeitspanne von 5 bis 20 Sekunden, gemessen den abrupten Erhöhungen dieses Gesamtstroms in einer Reaktionszeit von etwa 5 Sekunden.

2. Ein Detektor gemäss des Patentanspruches 1, sich durch ein Heizelement auszeichnend, das aus zwei Lamellen (3, 4) besteht, die, voneinander getrennt, sich parallel zueinander gegenüberstehen, indem der erste Thermistor (CTN 1) zwischen den zwei genannten Lamellen plaziert wird und indem der Block solider Materie aus geladenem Harz besteht, dessen Wärmeleitung und totale Masse in der Absicht, den gewünschten Wärmeleitwiderstand des genannten Blockes zu erhalten, determiniert sind.

3. Detektor entsprechend den Patentansprüchen 1 oder 2, sich dadurch auszeichnend, dass er ausserdem noch einen heizenden Widerstand, eingeschlossen in den Block (8) solider Materie enthält, um den genannten Block mit einer Spannweite konstanter Temperatur über der umgebenden Temperatur zu halten.

4. Detektor entsprechend den Patentansprüchen 1 oder 3, so weit als abhängig vom Patentanspruch 1, sich dadurch auszeichnend, dass das Heizelement durch ein einziges Teil, dass der erste Thermistor in der Reichweite des genannten Heizelementes angebracht ist, wobei dieses (letzteres) direkt durch eine Photographie auf eine gedruckte Schaltung erhalten wird. Der Block solider Materie ist aus geladenem Harz geformt, dessen Leitfähigkeit und totale Masse so festgelegt sind, dass der gewünschte Wärmeleitwiderstand des genannten Blockes erreicht wird.

FIG. 1

FIG. 2

FIG. 3

FIG. 4

FIG. 5

FIG. 6